# EUROPEAN PATENT APPLICATION

(11) **EP 3 091 826 A2**
(43) Date of publication of application: **09.11.2016**
(21) Application number: 14791464.2
(22) Date of filing: 29.05.2014
(51) Int. Cl.: H05K 7/20

(54) **THERMAL CONTROL SYSTEM FOR CLOSED ELECTRONIC PLATFORM**

(30) Priority: 31.12.2013 CN 201310753812
(71) Applicant: ZTE Corporation, Shenzhen City, Guangdong Province 518057 (CN)
(72) Inventor: WU, Qiong, Shenzhen Guangdong Province 518057 (CN); JING, Baiheng, Shenzhen Guangdong Province 518057 (CN); WANG, Biaohua, Shenzhen Guangdong Province 518057 (CN); LI, Shuai, Shenzhen Guangdong Province 518057 (CN)
(74) Representative: Novagraaf Technologies
(86) International application number: PCT/CN2014/078831
(87) International publication number: WO 2014/177102

(57) **Abstract**

The embodiments of disclosure disclose a thermal control system for a closed electronic platform. The thermal control system includes two mutually independent heat exchange cavities; each heat exchange cavity is provided with an air inlet (10) and an air outlet (20); one heat exchanger is arranged in each of the two heat exchange cavities; the two heat exchangers are interconnected with each other through guide pipes to form a working medium circulating loop; each of tow heat exchangers includes a plurality of microchannel thermo-capillaries (140) and two runoff gathering pits (80); the plurality of microchannel thermo-capillaries (140) are arranged between the two runoff gathering pits (80) in a parallel connection manner; the runoff gathering pits (80) of the two heat exchangers are connected through the guide pipes, wherein each of the plurality of microchannels (141) which is arranged in parallel are formed in each microchannel thermo-capillary (140). The embodiments of the disclosure improves a driving capacity of working medium flow in the thermal control system for the closed electronic platform, thus improving a heat dissipation efficiency of the thermal control system, and improving an operation reliability of the electronic platform.

## Description

### Technical Field

The disclosure relates to the field of thermal control, and in particular to a thermal control system for a closed electronic platform.

### Background

With the progress of electronic technologies, electronic components and devices are developing to high performance, compactness and minimization. An integration degree, a packaging density and a working frequency of a chip are continuously increased therewith, and a power consumption of a high-heat-flux density heating chip (such as a Central Processing Unit (CPU), a Graphics Processing Unit (GPU) and a Light Emitting Diode (LED)) is increasing every day. However, in many industrial and military fields, and in particular in communication industries, the electronic components and devices need to be placed in a closed equipment platform, in order to prevent damage, caused by dust, corrosive gas, mildews and the like, to the electronic components. However, a closed environment makes a heat dissipation environment for an electronic component in the platform get worse and worse, leading to overheat and failure of the electronic component. Therefore, it is an urgent need to adopt necessary thermal control technology to dissipate heat in the closed electronic platform in time, so as to ensure efficient and reliable operation of the electronic platform.

In the related art, heat dissipation is generally realized in a working medium flowing way. Heat will be absorbed or released in a working medium flowing process, thus realizing heat dissipation in the closed electronic platform. However, the thermal control system in the related art is still low in heat dissipation efficiency, so that normal operation of the electronic platform is affected.

The contents above are only intended to assist the technical solution of the disclosure, but do not represent the related art.

### Summary

The embodiments of disclosure solve a problem in the related art that a thermal control system is low in heat dissipation efficiency.

In one embodiment of the disclosure, a thermal control system for a closed electronic platform is provided, including two mutually independent heat exchange cavities, wherein each heat exchange cavity is provided with an air inlet and an air outlet; one heat exchanger is arranged in each of the two heat exchange cavities; the two heat exchangers are interconnected with each other through a guide pipe to form a working medium circulating loop, and each of the two heat exchangers include a plurality of microchannel thermo-capillaries and two runoff gathering pits; the plurality of microchannel thermo-capillaries are arranged between the two runoff gathering pits in a parallel connection manner; the runoff gathering pits of the two heat exchangers are connected through the guide pipe, wherein each of the plurality of microchannel thermo-capillaries is provided with a plurality of parallel microchannels.

In an example embodiment, a section shape of each of the plurality of microchannels is a rectangular, a trapezoid, a triangular, a waveform-shaped or a Ω-shaped.

In an example embodiment, a section shape of each of the plurality of mcirochannel thermo-capillaries is a rectangular or a trapezoid.

In an example embodiment, the plurality of mcirochannel thermo-capillaries are arranged in parallel.

In an example embodiment, further including fins fixedly connected between every two adjacent mcirochannel thermo-capillaries.

In an example embodiment, at least one air driving devices for driving air in the heat exchange cavities to flow in a circulating manner is arranged at the air inlet and/or the air outlet of each of the heat exchange cavities.

In an example embodiment, a dust proof mesh is arranged at the air inlet.

The thermal control system for the closed electronic platform takes the microchannels in the mcirochannel thermo-capillaries as working medium circulating channels. Working mediums flow in the microchannels to cause phase change, thus generating heat exchange, and dissipating heat in the electronic platform to an external environment. As the thermal control system applies the microchannels in the mcirochannel thermo-capillaries as the working medium circulating channels, the working mediums are subjected to action caused by capillary pressure difference in pipelines. The capillary pressure difference generates thermal capillary force which sucks the working mediums to increase the speed that the working mediums flow in the system, so that the heat exchange efficiency of the system is improved, and the problem in the related art that the thermal control system in the electronic platform is low is solved.

### Brief Description of Drawings

The drawings are described here to provide further understanding of the disclosure, and form a part of the disclosure. The schematic embodiments and description of the disclosure are adopted to explain the disclosure, and do not form improper limits to the disclosure. In the drawings:
Fig. 1 shows a explosion schematic diagram of a thermal control system for a closed communication electronic platform according to an embodiment of the disclosure;
Fig. 2 shows a structural schematic diagram of heat exchangers in Fig. 1;
Fig. 3 shows a partially amplified structural schematic diagram of A in Fig. 2;
Fig. 4 shows a structural diagram of microchannel thermo-capillaries of heat exchangers according to an embodiment in Fig. 1;
Fig. 5 shows a partially amplified structural schematic diagram of B in Fig. 4;
Fig. 6 shows a structural diagram of microchannel thermo-capillaries of heat exchangers according to another embodiment in Fig. 1;
Fig. 7 is a partially amplified structural schematic diagram of C in Fig. 6.

Aim implementation, functional characteristics and advantages of the disclosure are further described with reference to the drawings with embodiments.

### Detailed Description

It should be understood that the specific embodiment described here is only intended to explain the disclosure, but not intended to limit the disclosure. It needs to be noted that the embodiments of the disclosure and the characteristics in the embodiments can be combined under the condition of no conflicts.

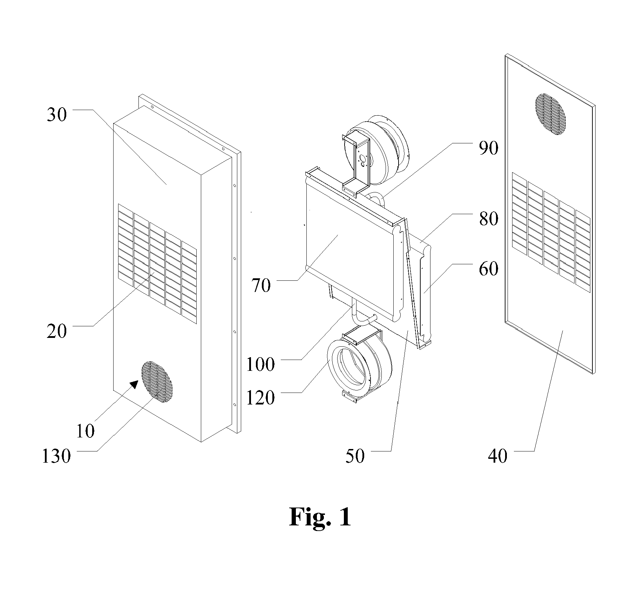

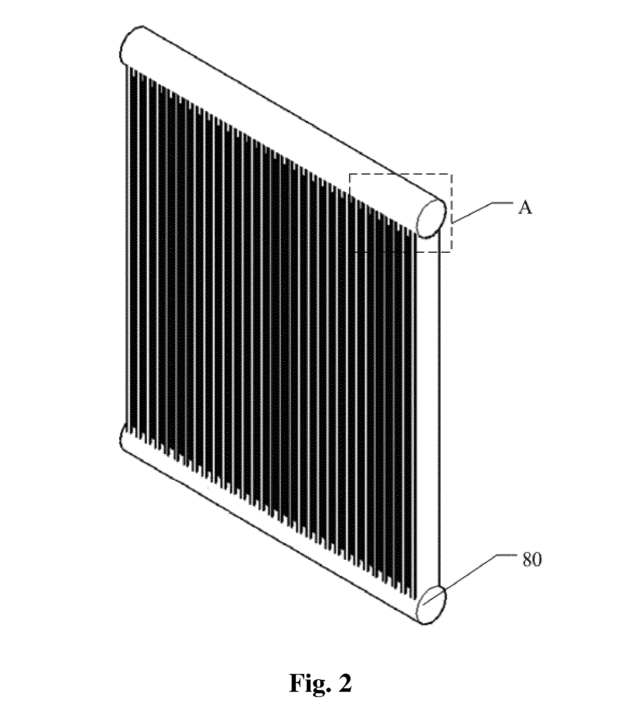

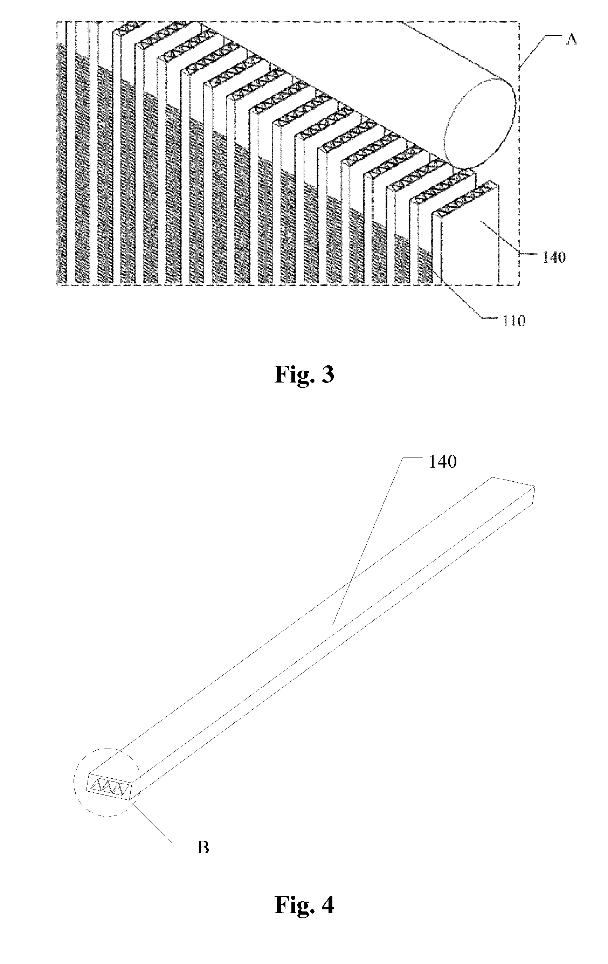

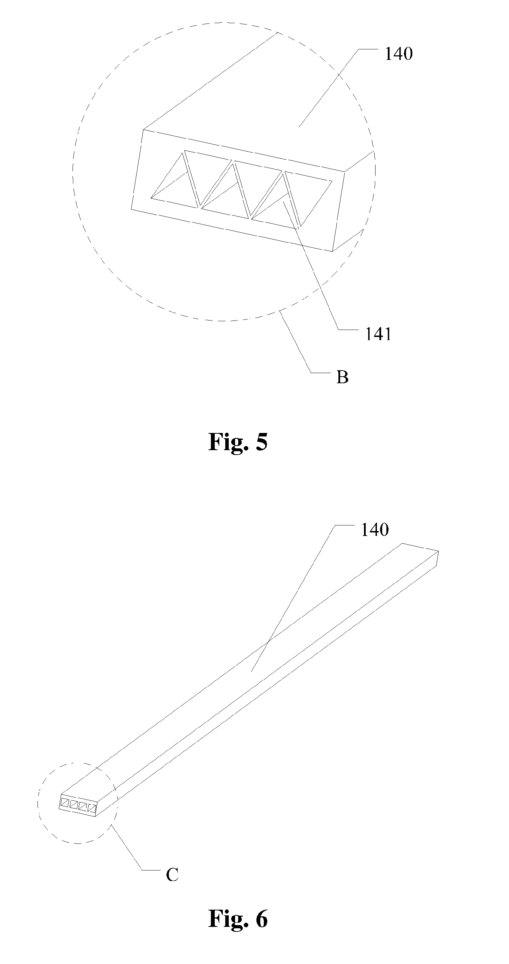

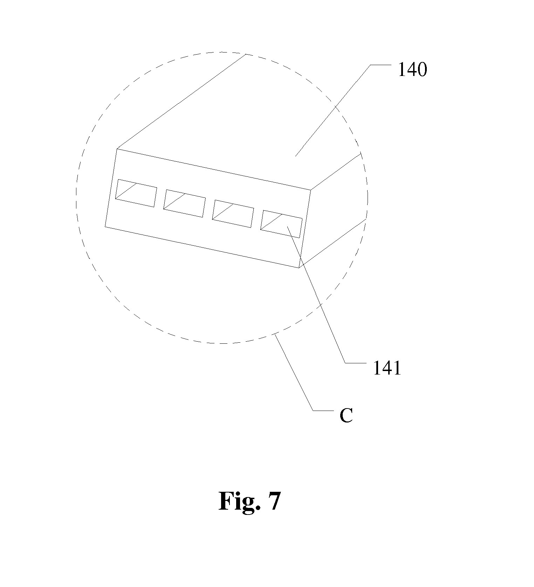

With reference to Fig. 1 to Fig. 7, Fig. 1 shows a explosion schematic diagram of a thermal control system for a closed communication electronic platform according to an embodiment of the disclosure; Fig. 2 shows a structural schematic diagram of heat exchangers in Fig. 1; Fig. 3 shows a partially amplified structural schematic diagram of A in Fig. 2; Fig. 4 shows a structural schematic diagram of microchannel thermo-capillaries of heat exchangers according to an embodiment in Fig. 1; Fig. 5 shows a partially amplified structural schematic diagram of B in Fig. 4; Fig. 6 shows a structural schematic diagram of microchannel thermo-capillaries of heat exchangers according to another embodiment in Fig. 1; Fig. 7 is a partially amplified structural schematic diagram of C in Fig. 6.

In an example embodiment of the disclosure, a thermal control system for a closed electronic platform includes two mutually independent heat exchange cavities. Each heat exchange cavity is provided with an air inlet 10 and an air outlet 20; one heat exchanger is arranged in each of the two heat exchange cavities; the two heat exchangers are interconnected with each other through a guide pipe to form a working medium circulating loop; each heat exchanger includes a plurality of microchannel thermo-capillaries 140 and two runoff gathering pits 80; the plurality of microchannel thermo-capillaries 140 are arranged between the two runoff gathering pits 80 in a parallel connection manner; one ends of the plurality of microchannel thermo-capillaries 140 are connected with one runoff gathering pit 80, and the other ends of the microchannel thermo-capillaries 140 are connected with the other runoff gathering pit 80; the runoff gathering pits 80 of the two heat exchangers are connected through the guide pipe, wherein a plurality of microchannels 141 which are arranged in parallel are formed in each microchannel thermo-capillary 140.

The two heat exchangers are mutually independent. To facilitate understanding, the two heat exchange cavities are respectively defined to be a cold heat exchange cavity and a thermal heat exchange cavity, wherein, the cold heat exchange cavity is interconnected with the outside through the air inlet 10 and the air outlet 20 formed on the cold heat exchange cavity and the thermal heat exchange cavity is connected with the closed electronic platform through the air inlet 10 and the air outlet 20 formed on the thermal heat exchange cavity. To improve a compactness of the thermal control system, reduce an use space occupied by the system on the closed electronic platform and facilitate installation and maintenance of a heat exchange system, the cold heat exchange cavity and the thermal heat exchange cavity are formed in a box body 30 with a lateral opening. A box cover 40 is arranged at the opening of the box body 30, and covers the opening of the box body 30; in addition, the box cover 40 is fixedly connected with the box body 30 through rivets. A partition plate 50 is arranged in the box body 30, and fastened with an inner surface of the box body 30 to divide the box body 30 into the cold heat exchange cavity and the thermal heat exchange cavity which are mutually independent. The cold heat exchange cavity of the box body 30 is provided with the air inlet 10 and the air outlet 20 which are interconnected with the outside. The air inlet 10 and the air outlet 20 which are connected with the closed electronic platform are formed in the thermal heat exchange cavity of the box body 30.

There are two heat exchangers, wherein a heat exchanger arranged in the cold heat exchange cavity is a condenser 60, and a heat exchanger arranged in the thermal heat exchange cavity is an evaporator 70. The condenser 60 includes a plurality of microchannel thermo-capillaries 140 arrayed side by side and two runoff gathering pits 80, wherein, a plurality of microchannels 141 for circulating working mediums are arrayed in each microchannel thermo-capillary 140 side by side. The two runoff gathering pits 80 are connected with the two end parts of each microchannel thermo-capillary 140. Of course, the evaporator 70 is of the same structure as the condenser 60, no more descriptions will be given here.

Guide pipes for connecting the condenser 60 with the evaporator 70 are respectively a rising pipe 90 and a backflow pipe 100, wherein, the rising pipe 90 penetrates through the partition plate 50 to connect the runoff gathering pit 80 for collecting air working mediums in the condenser 60 with the runoff gathering pit 80 for collecting air working mediums in the evaporator 70. The backflow pipe 100 penetrates through the partition plate 50 to connect the runoff gathering pit 80 for collecting liquid working mediums in the condenser 60 with the runoff gathering pit 80 for collecting liquid working mediums in the evaporator 70. There may be a single rising pipe 90 and a single backflow pipe 100, or a plurality of rising pipes 90 and a plurality of backflow pipes 100.

The working theory of the thermal control system is as follows: hot air in the closed communication electronic platform enters the thermal heat exchange cavity through the air inlet 10 of the thermal heat exchange cavity; cold air in an external environment enters the cold heat exchange cavity through the air inlet 10 of the cold heat exchange cavity. The hot air sweeps through the evaporator 70; liquid working mediums positioned in the microchannels 141 of the microchannel thermo-capillaries 140 in the evaporator 70 absorb heat brought by the hot air, and are turned into air working mediums after being evaporated by heat. The air working mediums rise and enter into the runoff gathering pits 80 at an upper end of the evaporator 70, pass through the partition plate 50 through the rising pipe 90, and enter the runoff gathering pits 80 at an upper end of the condenser 60. The air working mediums are divided into the microchannels 141 of the microchannel thermo-capillaries 140 in the condenser 60. The air working mediums and the cold air in the external environment exchange heat. The air working mediums are condensed to release heat here, to become liquid working mediums. The liquid working mediums are gathered in the runoff gathering pits 80 at a lower end of the condenser 60, pass through the partition plate 50 through the backflow pipe 100, and enter the runoff gathering pits 80 at a lower end of the evaporator 70. The liquid working mediums upwards move under a suction action of the thermal capillary force generated by the microchannels 141 of the microchannel thermo-capillaries 140 of the evaporator 70, enter the microchannels 141 of the microchannel thermo-capillaries 140, and are heated to be evaporated again. Cyclically, the working mediums realize phase change to dissipate the heat generated by the closed communication electronic platform to the external environment.

It should be noted that the working mediums may be any liquid working medium such as water, ammonia, ethyl alcohol, propyl alcohol, acetone, organic matters and refrigerants.

The thermal control system for the closed electronic platform of the embodiments of the disclosure takes the microchannels 141 in the mcirochannel thermo-capillaries 140 as working medium circulating channels. Working mediums flow in the microchannels 141 to cause phase change, thus generating heat exchange, and dissipating heat in the electronic platform to the external environment. As the thermal control system applies the microchannels 141 in the mcirochannel thermo-capillaries 140 as the working medium circulating channels, the working mediums are subjected to action caused by capillary pressure difference in pipelines. The capillary pressure difference generates thermal capillary force which sucks the working mediums to increase the speed that the working mediums flow in the system, so that the heat exchange efficiency of the system is improved, and the problem in the related art that the thermal control system in the electronic platform is low is solved.

Furthermore, a section shape of each of the plurality of mcirochannel thermo-capillaries 140 is a rectangular or a trapezoid; a section shape of each of the plurality of microchannels 141 is a rectangular, a trapezoid, a triangular, a waveform-shaped or a Ω-shaped.

In this embodiment, the microchannels 141 of the microchannel thermo-capillaries 140 may be of various shapes; for example, the section shape may be a rectangular, a trapezoid, a triangular, a waveform-shaped or a Ω-shaped, so that higher thermal capillary force can be generated at the internal corner of each microchannel 141; therefore, the circulating speed of the working mediums in the system is increased, and the heat dissipation efficiency of the thermal control system is improved.

Furthermore, to make the heat exchangers better in heat dissipation effect and make structures of the heat exchangers tidier and attractive, the plurality of microchannel thermo-capillaries 140 may be arranged in parallel.

Furthermore, fins 110 fixedly connected between every two adjacent mcirochannel thermo-capillaries 140 arranged on the mcirochannel thermo-capillaries 140.

In this embodiment, the fins 110 are mounted between every two adjacent mcirochannel thermo-capillaries 140 in fixing ways such as welding. Via the existence of the fins 110, the heat exchange area is greatly enlarged, thus further improving the heat exchange efficiency of the thermal control system, and better dissipating heat of the electronic platform. It should be noted that there may be a plurality of fins 110 which can be various conventional fins such as square fins, waveform-shaped fins, louver-shaped fins, abnormal direction parallel fins and arc-shaped transverse tangent fins. The fins 110 are made of different materials, such as copper, aluminum, carbon steel, stainless steel and cast iron, which are selected according to a working environment.

Furthermore, at least one air driving devices 120 for driving air in the heat exchange cavities to flow in a circulating manner is arranged at the air inlets 10 of the heat exchange cavities.

The at least one air driving devices 120 is arranged at the air inlet 10 of the cold heat exchange cavity, and configured to drive air convection between the condenser 60 and the external environment. The at least one air driving devices 120 is arranged at the air inlet 10 of the thermal heat exchange cavity, configured to drive air convection between the evaporator 70 and the internal environment of the electronic platform. By the arrangement of the at least one air driving devices 120, a circulating speed of air in the system is increased, thus further improving the heat dissipation efficiency of the thermal control system for the closed electronic platform; therefore, the thermal control system can better dissipate heat of the electronic platform, and normal and reliable operation of the electronic platform is further guaranteed. In the embodiment, the at least one air driving devices 120 is a centrifugal fan. The centrifugal fans are fixed on the partition plate 50 through brackets close to the air inlets 10. The brackets may be made of different materials, such as copper, aluminum, carbon steel, stainless steel and cast iron, which are selected according to a working environment. It should be noted that the at least one air driving devices 120 may be an axial flow fan. In addition, the at least one air driving devices 120 can be also arranged at the air outlet 20, or the at least one air driving devices 120 is simultaneously arranged at the air inlet 10 and the air outlets, to accelerate air circulation of the thermal control system. The at least one air driving devices 120 can be set alternatively according to an actual situation.

Furthermore, a dust proof mesh 130 is arranged at the air inlet 10.

In the embodiment, to prevent large-particulate foreign matters such as dust in the external environment from entering the heat exchange cavities through the air inlets and corroding parts in the cavities, causing failure of parts, the dust proof mesh 130 is additionally arranged in the embodiment. The dust proof mesh 130 covers the air inlets 10, to effectively prevent the foreign matters such as dust from entering the heat exchange cavities, so that a service life of the heat exchange system is effectively guaranteed.

The above are only example embodiments of the disclosure, and not intended to limit the scope of patent of the disclosure therefore. Transformations for equivalent structures or equivalent processes which is made according to the description and drawings, or directly or indirectly applied to other relevant technical fields shall fall within the scope of protection of patent of the disclosure by the same reasoning.

## Claims

1. A thermal control system for a closed electronic platform, comprising two mutually independent heat exchange cavities, wherein each heat exchange cavity is provided with an air inlet and an air outlet; one heat exchanger is arranged in each of the two heat exchange cavities; the two heat exchangers are interconnected with each other through a guide pipe to form a working medium circulating loop, and each of the two heat exchangers comprise a plurality of microchannel thermo-capillaries and two runoff gathering pits; the plurality of microchannel thermo-capillaries are arranged between the two runoff gathering pits in a parallel connection manner; the runoff gathering pits of the two heat exchangers are connected through the guide pipe, wherein each of the plurality of microchannel thermo-capillaries is provided with a plurality of parallel microchannels.

2. The thermal control system for the closed electronic platform as claimed in claim 1, wherein a section shape of each of the plurality of microchannels is a rectangular, a trapezoid, a triangular, a waveform-shaped or a Ω-shaped.

3. The thermal control system for the closed electronic platform as claimed in claim 1, wherein a section shape of each of the plurality of mcirochannel thermo-capillaries is a rectangular or a trapezoid.

4. The thermal control system for the closed electronic platform as claimed in claim 1, wherein the plurality of mcirochannel thermo-capillaries are arranged in parallel.

5. The thermal control system for the closed electronic platform as claimed in claim 4, further comprising fins fixedly connected between every two adjacent mcirochannel thermo-capillaries.

6. The thermal control system for the closed electronic platform as claimed in claim 1, wherein at least one air driving devices for driving air in the heat exchange cavities to flow in a circulating manner is arranged at the air inlet and/or the air outlet of each of the heat exchange cavities.

7. The thermal control system for the closed electronic platform as claimed in claim 1 or 6, wherein a dust proof mesh is arranged at the air inlet.
